# EUROPEAN PATENT SPECIFICATION

(11) **EP 2 488 004 B1**
(45) Date of publication and mention of the grant of the patent: **30.08.2017**
(21) Application number: 11765092.9
(22) Date of filing: 12.05.2011
(51) Int. Cl.: H05K 5/06, H02B 1/28, H02B 1/38

(54) **WATERPROOF MACHINE CABINET**
WASSERFESTES MASCHINENGEHÄUSE
ARMOIRE DE MACHINE ÉTANCHE À L'EAU

(43) Date of publication of application: 15.08.2012
(73) Proprietor: Huawei Technologies Co., Ltd., Longgang District Shenzhen, Guangdong 518129 (CN)
(72) Inventor: LONG, Jinsong, Shenzhen Guangdong 518129 (CN); REN, Jianguang, Shenzhen Guangdong 518129 (CN); ZHANG, Dongdong, Shenzhen Guangdong 518129 (CN)
(74) Representative: Isarpatent
(86) International application number: PCT/CN2011/073993
(87) International publication number: WO 2011/124174

(56) References cited:
- CN-U- 201 491 426
- CN-Y- 2 521 870
- CN-Y- 2 872 800
- DE-U- 7 520 183
- FR-A- 1 120 592
- FR-A1- 2 581 826

## Description

### FIELD OF THE INVENTION

The present invention relates to waterproof technologies, and in particular, to a waterproof cabinet.

### BACKGROUND OF THE INVENTION

Waterproofing is a most fundamental requirement for a cabinet of an outdoor communication apparatus. A waterproof cabinet in the prior art is formed by a cabinet body and a door plate.

The periphery of the door plate is disposed with a door frame. A waterproof rubber strip is attached on the door frame and capable of sticking between the door plate and the cabinet body. However, the waterproof rubber strip disposed in the waterproof cabinet of the prior art is an ordinary strip-type waterproof rubber strip, which is directly disposed on the door frame and has merely one surface connecting with the door plate, as a result leakages may easily occur. The waterproof effect is poor. Therefore, the normal operation of components inside the cabinet is affected.

FR 2581826 A1 discloses a method and device for mounting, with improved sealing, a door or a cover of a case or cabinet. At least one intermediate piece is used having the shape of a wedge matching the rim of the casing and comprising a tapped borehole which is directed substantially perpendicular to the closure plane of the casing enable the door to be fixed and tightened by means of a through-screw.

DE 75 20 183 U discloses a cabinet with tightly fitting door, and the gap between the cabinet and the associated door is sealed by inserted foam strips of elastic material.

FR 1120592 A discloses boxes connecting electrical conductors, wherein on two opposite sides of the box, large flanges drilled during stamping, is suitable for right or left articulation hinges covers.

### SUMMARY OF THE INVENTION

Embodiments of the present invention provide a waterproof cabinet, so as to increase the reliability of waterproofing and ensure the normal operation of components inside the cabinet.

An embodiment of the present invention provides a waterproof cabinet, which includes a cabinet body and a door plate; where
the periphery of the door plate is wrapped with a first metal section which has a U-shaped cross section;
a second metal section protrudes from a side of the first metal section, facing to the cabinet body; the second metal section is set with a waterproof device against the first metal section, where the waterproof device is configured to abut upon the cabinet body when the door plate and the cabinet body close up;
wherein the waterproof device comprises a waterproof rubber strip; the waterproof rubber strip is correspondingly pressed by a waterproof pressing strip, configured to press the waterproof rubber strip to form a U-shaped slot; the waterproof device is disposed on the second metal section by a bolt which passing through the waterproof pressing strip, the waterproof rubber strip and the second metal section; wherein
the waterproof rubber strip comprises a connecting surface and two contact surfaces; the connecting surface of the waterproof rubber strip is configured to connect the second metal section; one contact surface of the waterproof rubber strip is configured to contact a side of the first metal section corresponding to the cabinet body; and the other contact surface of the waterproof rubber strip is configured to abut upon the cabinet body when the door plate and the cabinet body close up.

An embodiment of the present invention provides a waterproof cabinet, comprising a cabinet body and a door plate; where
the periphery of the door plate is wrapped with a first metal section which has a U-shaped cross section;
a second metal section protrudes from a side of the first metal section, facing to the cabinet body; and
the second metal section is disposed with a waterproof device against the first metal section; the waterproof device is configured to abut upon the cabinet body when the door plate and the cabinet body close up;
wherein a third metal section protrudes from a side of the second metal section, facing to a direction at which the waterproof device is disposed; the waterproof device comprises one waterproof rubber strip and another waterproof rubber strip disposed on a side of the third metal section corresponding to the cabinet body; and the one waterproof rubber strip is correspondingly pressed by a waterproof pressing strip, configured to press the one waterproof rubber strip to form a slot; wherein
the one waterproof rubber strip comprises a connecting surface and two contact surfaces; the another waterproof rubber strip comprises a connecting surface and a contact surface; the connecting surface of the one waterproof rubber strip is configured to connect the second metal section; one contact surface of the one waterproof rubber strip is configured to contact a side of the first metal section corresponding to the cabinet body; the other contact surface of the one waterproof rubber strip is configured to contact a side of the third metal section corresponding to
the door plate; the connecting surface of the another waterproof rubber strip is configured to connect a side of the third metal section corresponding to the cabinet body; and the contact surface of the another waterproof rubber strip is configured to abut upon the cabinet body when the door plate and the cabinet body close up.

An embodiment of the present invention provides a waterproof cabinet, comprising a cabinet body and a door plate; where
the periphery of the door plate is wrapped with a first metal section which has a U-shaped cross section;
a second metal section protrudes from a side of the first metal section, facing to the cabinet body; and
the second metal section is disposed with a waterproof device against the first metal section; the waterproof device is configured to abut upon the cabinet body when the door plate and the cabinet body close up;
wherein a third metal section protrudes from a side of the second metal section, facing to a direction at which the waterproof device is disposed; the waterproof device comprises one waterproof rubber strip and another waterproof rubber strip sleeved on the third metal section; and the one waterproof rubber strip is correspondingly pressed by a waterproof pressing strip, configured to press the waterproof rubber strip to form a slot, wherein
the one waterproof rubber strip comprises a connecting surface and two contact surfaces; the another waterproof rubber strip comprises a connecting surface and two contact surfaces; the connecting surface of the one waterproof rubber strip is configured to connect the second metal section; one contact surface of the one waterproof rubber strip is configured to contact a side of the first metal section corresponding to the cabinet body; the other contact surface of the one waterproof rubber strip is configured to contact one contact surface of the another waterproof rubber strip; the connecting surface of the another waterproof rubber strip is configured to connect a side of the third metal section corresponding to the cabinet body and a side of the third metal section corresponding to the door plate; and the other contact surface of the another waterproof rubber strip is configured to abut upon the cabinet body when the door plate and the cabinet body close up.

An embodiment of the present invention provides a waterproof cabinet, comprising a cabinet body and a door plate; where
the periphery of the door plate is wrapped with a first metal section which has a U-shaped cross section;
a second metal section protrudes from a side of the first metal section, facing to the cabinet body; and
the second metal section is disposed with a waterproof device against the first metal section; the waterproof device is configured to abut upon the cabinet body when the door plate and the cabinet body close up;
wherein a third metal section protrudes from a side of the second metal section, facing to a direction at which the waterproof device is disposed; the waterproof device comprises one waterproof rubber strip and another waterproof rubber strip sleeved on the third metal section; and the one waterproof rubber strip is correspondingly pressed by a waterproof pressing strip, configured to press the waterproof rubber strip to form a slot, wherein
the one waterproof rubber strip comprises a connecting surface and two contact surfaces; the another waterproof rubber strip comprises a connecting surface and two contact surfaces; the connecting surface of the one waterproof rubber strip is configured to connect the second metal section; one contact surface of the one waterproof rubber strip is configured to contact a side of the first metal section corresponding to the cabinet body; the other contact surface of the one waterproof rubber strip is configured to contact one contact surface of the another waterproof rubber strip; the connecting surface of the another waterproof rubber strip is configured to connect a side of the third metal section corresponding to the cabinet body and a side of the third metal section corresponding to the door plate; and the other contact surface of the another waterproof rubber strip is configured to abut upon the cabinet body when the door plate and the cabinet body close up.

An embodiment of the present invention provides a waterproof cabinet, comprising a cabinet body and a door plate; where
the periphery of the door plate is wrapped with a first metal section which has a U-shaped cross section;
a second metal section protrudes from a side of the first metal section, facing to the cabinet body; and
the second metal section is disposed with a waterproof device against the first metal section; the waterproof device is configured to abut upon the cabinet body when the door plate and the cabinet body close up;
wherein a third metal section protrudes from a side of the second metal section, facing to a direction at which the waterproof device is disposed; the waterproof device comprises one waterproof rubber strip and another waterproof rubber strip disposed on a side of the third metal section corresponding to the cabinet body; and the one waterproof rubber strip is correspondingly pressed by a waterproof pressing strip, configured to press the one waterproof rubber strip to form a slot, wherein
the one waterproof rubber strip comprises a connecting surface and a contact surface; the another waterproof rubber strip comprises a connecting surface and a contact surface; the connecting surface of the one waterproof rubber strip is configured to connect the second metal section; the contact surface of the one waterproof rubber strip is configured to contact a side of the first metal section corresponding to the cabinet body; the connecting surface of the another waterproof rubber strip is configured to connect a side of the third metal section corresponding to the cabinet body; and the contact surface of the another waterproof rubber strip is configured to fit with the cabinet body when the door plate and the cabinet body close up.

It can be known from the technical solutions that, in the embodiments of the present invention, the second metal section protrudes from a side of the first metal section set on the periphery of the door plate, facing to the cabinet body, so that the waterproof device may be set on the second metal section. The waterproof device and the door plate have a connecting surface (namely, a connecting surface between the waterproof device and the second metal section) and a contact surface (namely, a contact surface between the waterproof device and the first metal section), so the reliability of waterproofing is increased, thereby ensuring normal operation of the components inside the cabinet.

### BRIEF DESCRIPTION OF THE DRAWINGS

To illustrate the technical solutions according to the embodiments of the present invention or in the prior art more clearly, the accompanying drawings for describing the embodiments or the prior art are introduced briefly in the following. Apparently, the accompanying drawings in the following description are only some embodiments of the present invention, and persons of ordinary skill in the art can derive other drawings from the accompanying drawings without creative efforts.
FIG. 1 is a schematic structural diagram of a waterproof cabinet provided by an embodiment of the present invention;
FIG. 2 is a schematic structural diagram of a bend formed by each of two ends of a U-shaped waterproof pressing strip of a waterproof cabinet provided by another embodiment of the present invention;
FIG. 3 is a schematic structural diagram of a waterproof cabinet provided by another embodiment of the present invention;
FIG. 4 is a schematic structural diagram of a waterproof cabinet provided by another embodiment of the present invention; and
FIG. 5 is a schematic structural diagram of a waterproof cabinet provided by another embodiment of the present invention.

### DETAILED DESCRIPTION OF THE EMBODIMENTS

In order to make the objectives, technical solutions, and advantages of the present invention more comprehensible, the technical solutions according to embodiments of the present invention are clearly and completely described in the following with reference to the accompanying drawings. Obviously, the embodiments in the following description are merely a part rather than all of the embodiments of the present invention.

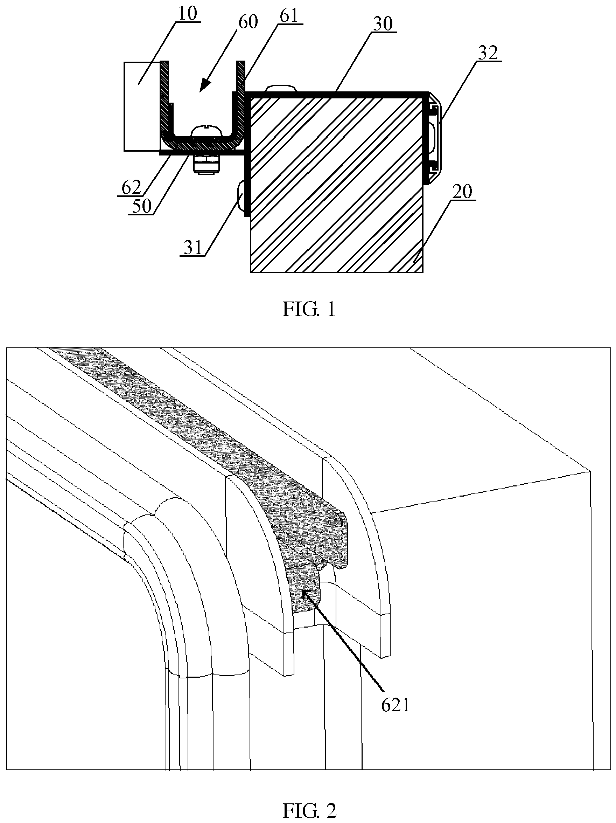

FIG. 1 is a schematic diagram of a waterproof cabinet provided by an embodiment of the present invention. As shown in FIG. 1, an embodiment of the waterproof cabinet includes a cabinet body 10 and a door plate 20. The periphery of the door plate 20 is set with a first metal section 30. A second metal section 50 protrudes from a side of the first metal section 30, facing to the cabinet body 10. The second metal section 50 is set with a waterproof device 60 against the first metal section 30. The waterproof device 60 is configured to abut upon the cabinet body 10 when the door plate 20 and the cabinet body 10 close up. The first metal section 30 may be set on the periphery of the door plate 20 through a fastener 31.

It should be noted that, in this embodiment, the first metal section and the second metal section may be manufactured by using the technology of integrated forming.

In this embodiment, the second metal section protrudes from a side of the first metal section set on the periphery of the door plate, facing to the cabinet body, so that the waterproof device may be set on the second metal section. The waterproof device and the door plate have a connecting surface (namely, a connecting surface between the waterproof device and the second metal section) and a contact surface (namely, a contact surface between the waterproof device and the first metal section), so the reliability of waterproofing is increased, thereby ensuring normal operation of the components inside the cabinet.

As show in FIG. 1, the waterproof device 60 may include a waterproof rubber strip 61. The waterproof rubber strip 61 is correspondingly pressed by a waterproof pressing strip 62, which is configured to press the waterproof rubber strip 61 to form a groove. The waterproof rubber strip 61 may include a connecting surface and two contact surfaces. The connecting surface of the waterproof rubber strip 61 is configured to connect to the second metal section 50. One contact surface of the waterproof rubber strip 61 is configured to contact a side of the first metal section 30 corresponding to the cabinet body 10. The other contact surface of the waterproof rubber strip 61 is configured to abut upon the cabinet body 10 when the door plate 20 and the cabinet body 10 close up. Furthermore, two ends of the waterproof pressing strip 62 each bend towards a side where the second metal section 50 is located, to form a bend 621, so that two ends of the waterproof rubber strip 61 each form a bend shown in FIG. 2. In this way, water is prevented from permeating through joints of the first metal section 30 at corner portions of the door plate, so that the reliability of waterproofing is further increased. Preferably, the waterproof pressing strip 62 may press the waterproof rubber strip 61 to form a U-shaped groove. A bottom portion of the U-shaped slot faces to the connecting surface. Two side walls of the U-shaped slot respectively face to the two contact surfaces. That is to say, the waterproof device 60 is capable of forming two waterproof barriers (the two side walls of the pressed U-shaped slot of the waterproof rubber strip 61) between the door plate 20 and the cabinet body 10.

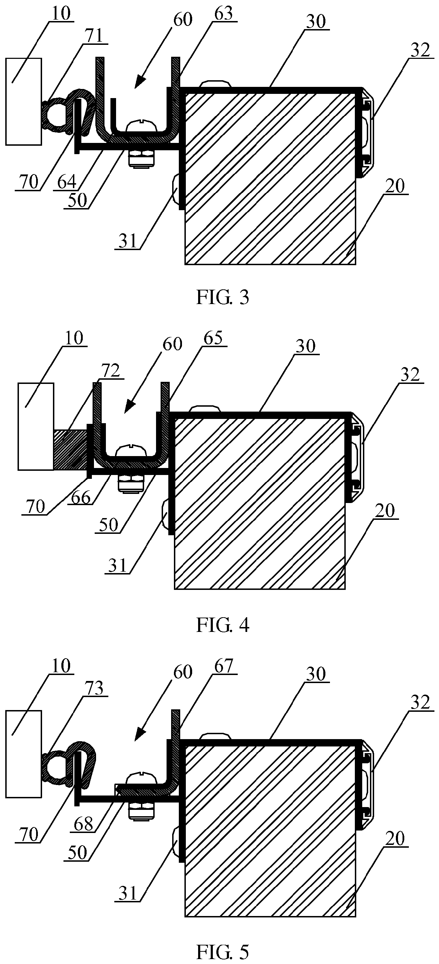

Furthermore, as shown in FIG. 3,4 and 5, a third metal section 70 protrudes from a side of the second metal section 50, facing to a direction at which the waterproof device 60 is disposed.

It should be noted that, in this embodiment, the first metal section, the second metal section and the third metal section may be manufactured by using the technology of integrated forming.

Alternatively, as shown in FIG. 3, the waterproof device includes a waterproof rubber strip 63 and another waterproof rubber strip 71 set on a side of the third metal section 70 corresponding to the cabinet body 10. The one waterproof rubber strip 63 is correspondingly pressed by a waterproof pressing strip 64, which is configured to press the one waterproof rubber strip 63 to form a groove. The one waterproof rubber strip 63 includes a connecting surface and two contact surfaces. The another waterproof rubber strip 71 includes a connecting surface and a contact surface. The connecting surface of the one waterproof rubber strip 63 is configured to connect the second metal section 50. One contact surface of the one waterproof rubber strip 63 is configured to contact a side of the first metal section 30 corresponding to the cabinet body 10. The other contact surface of the one waterproof rubber strip 63 is configured to contact a side of the third metal section 70 corresponding to the door plate 20. The connecting surface of the another waterproof rubber strip 71 is configured to connect a side of the third metal section 70 corresponding to the cabinet body 10. The contact surface of the another waterproof rubber strip 71 is configured to abut upon the cabinet body 10 when the door plate 20 and the cabinet body 10 close up. Furthermore, two ends of the waterproof pressing strip 64 bend towards a side where the second metal section 50 is located, so that two ends of the waterproof rubber strip 63 each form a bend. In this way, water is prevented from permeating through joints of the first metal section 30 at corner portions of the door plate, so that the reliability of waterproofing is further increased. Preferably, the waterproof pressing strip 64 may press the waterproof rubber strip 63 to form a U-shaped slot. A bottom portion of the U-shaped slot corresponds to the connecting surface. Two side walls of the U-shaped groove respectively correspond to the two contact surfaces. That is to say, the waterproof device 60 is capable of forming three waterproof barriers (namely, two waterproof barriers are the two side walls of the pressed U-shaped slot of the waterproof rubber strip 63; the other waterproof barrier is the another waterproof rubber strip 71) between the door plate 20 and the cabinet body 10.

Alternatively, as shown in FIG. 4, the waterproof device 60 may include a waterproof rubber strip 65 and another waterproof rubber strip 72 set on a side of the third metal section 70 corresponding to the cabinet body 10. The one waterproof rubber strip 65 is correspondingly pressed by a waterproof pressing strip 66, which is configured to press the one waterproof rubber strip 65 to form a groove. The one waterproof rubber strip 65 includes a connecting surface and two contact surfaces. The another waterproof rubber strip 72 includes a connecting surface and a contact surface. The connecting surface of the one waterproof rubber strip 65 is configured to connect the second metal section 50. One contact surface of the one waterproof rubber strip 65 is configured to contact a side of the first metal section 30 corresponding to the cabinet body 10. The other contact surface of the one waterproof rubber strip 65 is configured to contact a side of the third metal section 70 corresponding to the door plate 20. The connecting surface of the another waterproof rubber strip 72 is configured to connect a side of the third metal section 70 corresponding to the cabinet body 10. The contact surface of the another waterproof rubber strip 72 is configured to abut upon the cabinet body 10 when the door plate 20 and the cabinet body 10 close up. Furthermore, two ends of the waterproof pressing strip 66 each bend towards a side where the second metal section 50 is located, to form a bend, so that two ends of the waterproof rubber strip 65 each form a bend. In this way, water is prevented from permeating through joints of the first metal section 30 at corner portions of the door plate, so that the reliability of waterproofing is further increased. Preferably, the waterproof pressing strip 66 may press the one waterproof rubber strip 65 to form a U-shaped slot. A bottom portion of the U-shaped slot corresponds to the connecting surface. Two side walls of the U-shaped slot respectively correspond to the two contact surfaces. That is to say, the waterproof device 60 is capable of forming three waterproof barriers (namely, two waterproof barriers are the two side walls of the pressed U-shaped slot of the waterproof rubber strip 65; the other waterproof barrier is the another waterproof rubber strip 72) between the door plate 20 and the cabinet body 10.

Alternatively, as shown in FIG. 5, the waterproof device 60 may include a waterproof rubber strip 67 and another waterproof rubber strip 73 sleeved on the third metal section. The one waterproof rubber strip 67 is correspondingly pressed by a waterproof pressing strip 68, which is configured to press the one waterproof rubber strip 67 to form a slot. The one waterproof rubber strip 67 includes a connecting surface and a contact surface. The another waterproof rubber strip 73 includes a connecting surface and a contact surface. The connecting surface of the one waterproof rubber strip 67 is configured to connect the second metal section 50. The contact surface of the one waterproof rubber strip 67 is configured to contact a side of the first metal section 30 corresponding to the cabinet body 10. The connecting surface of the another waterproof rubber strip 73 is configured to connect a side of the third metal section 70 corresponding to the cabinet body 10 and a side of the third metal section 70 corresponding to the door plate 20. The contact surface of the another waterproof rubber strip 73 is configured to abut upon the cabinet body 10 when the door plate 20 and the cabinet body 10 close up. Furthermore, two ends of the waterproof pressing strip 68 each bend towards a side where the second metal section 50 is located, to form a bend, so that two ends of the waterproof rubber strip 67 each form a bend. In this way, water is prevented from permeating through joints of the first metal section 30 at corner portions of the door plate, so that the reliability of waterproofing is further increased. Preferably, the waterproof pressing strip 68 may press the one waterproof rubber strip 67 to form an L-shaped slot. A bottom portion of the L-shaped slot corresponds to the connecting surface. A side wall of the L-shaped slot corresponds to the contact surface. That is to say, the waterproof device 60 is capable of forming two waterproof barriers (namely, one waterproof barrier is the side wall of the pressed L-shaped slot of the waterproof rubber strip 67; the other waterproof barrier is the another waterproof rubber strip 73) between the door plate 20 and the cabinet body 10.

Alternatively, likewise, the another waterproof rubber strip 73 shown in FIG. 5 may be replaced by the another waterproof rubber strip 72 shown in FIG. 4. Specifically, the waterproof device may include a waterproof rubber strip 67 and another waterproof rubber strip 72 set on a side of the third metal section 70 corresponding to the cabinet body 10. The one waterproof rubber strip 67 is correspondingly pressed by a waterproof pressing strip 68, which is configured to press the one waterproof rubber strip 67 to form a groove. The one waterproof rubber strip 67 includes a connecting surface and a contact surfaces. The another waterproof rubber strip 72 includes a connecting surface and one contact surface. The connecting surface of the one waterproof rubber strip 67 is configured to connect the second metal section 50. The contact surface of the one waterproof rubber strip 67 is configured to contact a side of the first metal section 30 corresponding to the cabinet body 10. The connecting surface of the another waterproof rubber strip 72 is configured to connect a side of the third metal section 70 corresponding to the cabinet body 10. The contact surface of the another waterproof rubber strip 72 is configured to abut upon the cabinet body 10 when the door plate 20 and the cabinet body 10 close up. Furthermore, two ends of the waterproof pressing strip 68 each bend towards a side where the second metal section 50 is located, to form a bend, so that two ends of the waterproof rubber strip 67 each form a bend. In this way, water is prevented from permeating through joints of the first metal section 30 at corner portions of the door plate, so that the reliability of waterproofing is further increased. Preferably, the waterproof pressing strip 68 may press the one waterproof rubber strip 67 to form an L-shaped slot. A bottom portion of the L-shaped slot corresponds to the connecting surface. A side wall of the L-shaped slot corresponds to the contact surface. That is to say, the waterproof device 60 is capable of forming two waterproof barriers (namely, one waterproof barrier is the side wall of the pressed L-shaped slot of the waterproof rubber strip 67; the other waterproof barrier is the another waterproof rubber strip 72) between the door plate 20 and the cabinet body 10.

Furthermore, in view of appearance, this embodiment may further set a decorative cover plate 32 outside of the fastener 31.

Finally, it should be noted that the above embodiments are merely provided for describing the technical solutions of the present invention, It should be understood by persons of ordinary skill in the art that although the present invention has been described in detail with reference to the embodiments, modifications can be made to the technical solutions described in the embodiments, or equivalent replacements can be made to some technical features in the technical solutions.

## Claims

1. A waterproof cabinet, comprising a cabinet body (10) and a door plate (20), **characterized in that**
the periphery of the door plate is wrapped with a first metal section (30) which has a U-shaped cross section;
a second metal section (50) protrudes from a side of the first metal section (30), facing to the cabinet body (10); and the second metal section (50) is fitted with a waterproof device (60) against the first metal section (30); the waterproof device (60) is configured to abut upon the cabinet body (10) when the door plate (20) and the cabinet body (10) close up;
wherein the waterproof device (60) comprises a waterproof rubber strip (61); the waterproof rubber strip (61) is correspondingly pressed by a waterproof pressing strip (62), configured to press the waterproof rubber strip (61) to form a U-shaped slot; the waterproof device (60) is disposed on the second metal section (50) by a bolt passing through the waterproof pressing strip (62), the waterproof rubber strip (61) and the second metal section (50); wherein
the waterproof rubber strip (61) comprises a connecting surface and two contact surfaces; the connecting surface of the waterproof rubber strip (61) is configured to connect the second metal section (50); one contact surface of the waterproof rubber strip (61) is configured to contact a side of the first metal section (30) corresponding to the cabinet body (10); and the other contact surface of the waterproof rubber strip (61) is configured to abut upon the cabinet body (10) when the door plate (20) and the cabinet body (10) close up.

2. The waterproof cabinet according to claim 1, wherein two ends (621) of the waterproof pressing strip (62) each bend towards a side on which the second metal section (50) is located, to form a bend (621), so that two ends of the waterproof rubber strip (61) each form a bend.

3. A waterproof cabinet, comprising a cabinet body (10) and a door plate (20), **characterized in that**
the periphery of the door plate (20) is wrapped with a first metal section (30) which has a U-shaped cross section;
a second metal section (50) protrudes from a side of the first metal section (30), facing to the cabinet body (10); and the second metal section (50) is fitted with a waterproof device (60) against the first metal section (30); the waterproof device (60) is configured to abut upon the cabinet body (10) when the door plate (20) and the cabinet body (10) close up;
wherein a third metal section (70) protrudes from a side of the second metal section (50), facing to a direction at which the waterproof device (60) is disposed; the waterproof device (60) comprises one waterproof rubber strip (65) and another waterproof rubber strip (72) disposed on a side of the third metal section (70) corresponding to the cabinet body (10); and the one waterproof rubber strip (65) is correspondingly pressed by a waterproof pressing strip (66), configured to press the one waterproof rubber strip (65) to form a slot; wherein the one waterproof rubber strip (65) comprises a connecting surface and two contact surfaces; the another waterproof rubber strip (72) comprises a connecting surface and a contact surface; the connecting surface of the one waterproof rubber strip (65) is configured to connect the second metal section (50); one contact surface of the one waterproof rubber strip (65) is configured to contact a side of the first metal section (30) corresponding to the cabinet body (10); the other contact surface of the one waterproof rubber strip (65) is configured to contact a side of the third metal section (70) corresponding to the door plate (20); the connecting surface of the another waterproof rubber strip (72) is configured to connect a side of the third metal section (70) corresponding to the cabinet body (10); and the contact surface of the another waterproof rubber strip (72) is configured to abut upon the cabinet body (10) when the door plate (20) and the cabinet body (10) close up.

4. The waterproof cabinet according to claim 3, wherein two ends of the waterproof pressing strip (66) each bend towards a side on which the second metal section (50) is located, to form a bend, so that two ends of the waterproof rubber (65) each form a bend.

5. A waterproof cabinet, comprising a cabinet body (10) and a door plate (20), **characterized in that**
the periphery of the door plate (20) is wrapped with a first metal section (30) which has a U-shaped cross section;
a second metal section (50) protrudes from a side of the first metal section (30), facing to the cabinet body (10); and
the second metal section (50) is fitted with a waterproof device (60) against the first metal section (30); the waterproof device (60) is configured to abut upon the cabinet body (10) when the door plate (20) and the cabinet body (10) close up;
wherein a third metal section (70) protrudes from a side of the second metal section (50), facing to a direction at which the waterproof device (60) is disposed; the waterproof device (60) comprises one waterproof rubber strip (63) and another waterproof rubber strip (71) sleeved on the third metal section (70); and the one waterproof rubber strip (63) is correspondingly pressed by a waterproof pressing strip (64), configured to press the waterproof rubber strip to form a slot, wherein
the one waterproof rubber strip (63) comprises a connecting surface and two contact surfaces; the another waterproof rubber strip (71) comprises a connecting surface and two contact surfaces; the connecting surface of the one waterproof rubber strip (63) is configured to connect the second metal section (50); one contact surface of the one waterproof rubber strip (63) is configured to contact a side of the first metal section (30) corresponding to the cabinet body (10); the other contact surface of the one waterproof rubber strip (67) is configured to contact one contact surface of the another waterproof rubber strip (71); the connecting surface of the another waterproof rubber strip (71) is configured to connect a side of the third metal section (70) corresponding to the cabinet body (10) and a side of the third metal section (70) corresponding to the door plate (20); and the other contact surface of the another waterproof rubber strip (71) is configured to abut upon the cabinet body (10) when the door plate (20) and the cabinet body (10) close up.

6. The waterproof cabinet according to claim 5, wherein two ends of the waterproof pressing strip (64) each bend towards a side on which the second metal section (50) is located, to form a bend, so that two ends of the waterproof rubber strip each form a bend.

7. A waterproof cabinet, comprising a cabinet body (10) and a door plate (20), **characterized in that**
the periphery of the door plate (20) is wrapped with a first metal section (30) which has a U-shaped cross section;
a second metal section (50) protrudes from a side of the first metal section (30), facing to the cabinet body (10); and
the second metal section (50) is fitted with a waterproof device (60) against the first metal section (30); the waterproof device (60) is configured to abut upon the cabinet body (10) when the door plate (20) and the cabinet body (10) close up;
wherein a third metal section (70) protrudes from a side of the second metal section (50), facing to a direction at which the waterproof device (60) is disposed; the waterproof device (60) comprises one waterproof rubber strip (67) and another waterproof rubber strip (72) disposed on a side of the third metal section (70) corresponding to the cabinet body (10); and the one waterproof rubber strip (67) is correspondingly pressed by a waterproof pressing strip (68), configured to press the one waterproof rubber strip (67) to form a slot, wherein the one waterproof rubber strip (67) comprises a connecting surface and a contact surface; the another waterproof rubber strip (72) comprises a connecting surface and a contact surface; the connecting surface of the one waterproof rubber strip (67) is configured to connect the second metal section (50); the contact surface of the one waterproof rubber strip is configured to contact a side of the first metal section (30) corresponding to the cabinet body (10); the connecting surface of the another waterproof rubber strip is configured to connect a side of the third metal section (70) corresponding to the cabinet body (10); and the contact surface of the another waterproof rubber strip is configured to fit with the cabinet body (10) when the door plate (20) and the cabinet body (10) close up.

8. The waterproof cabinet according to claim 7, wherein two ends of the waterproof pressing strip (68) each bend towards a side on which the second metal section (50) is located, to form a bend, so that two ends of the one waterproof rubber strip (65) each form a bend.

9. A waterproof cabinet, comprising a cabinet body (10) and a door plate (20), **characterized in that**
the periphery of the door plate (20) is wrapped with a first metal section (30) which has a U-shaped cross section;
a second metal section (50) protrudes from a side of the first metal section (30), facing to the cabinet body (10); and
the second metal section (50) is fitted with a waterproof device (60) against the first metal section (30); the waterproof device (60) is configured to abut upon the cabinet body (10) when the door plate (20) and the cabinet body (10) close up;
wherein a third metal section (70) protrudes from a side of the second metal section (50), facing to a direction at which the waterproof device (60) is disposed; the waterproof device (60) comprises one waterproof rubber strip (67) and another waterproof rubber strip (73) sleeved on the third metal section (70); and the one waterproof rubber strip (67) is correspondingly pressed by a waterproof pressing strip (68), configured to press the one waterproof rubber strip (67) to form a slot, wherein
the one waterproof rubber strip (67) comprises a connecting surface and a contact surface; the another waterproof rubber strip (73) comprises a connecting surface and a contact surface; the connecting surface of the one waterproof rubber strip (67) is configured to connect the second metal section (50); the contact surface of the one waterproof rubber strip (67) is configured to contact a side of the first metal section (30) corresponding to the cabinet body (10); the connecting surface of the another waterproof rubber strip (73) is configured to connect a side of the third metal section (70) corresponding to the cabinet body (10) and a side of the third metal section (70) corresponding to the door plate (20); and the contact surface of the another waterproof rubber strip (73) is configured to fit with the cabinet body (10) when the door plate (20) and the cabinet body (10) close

10. The waterproof cabinet according to claim 9, wherein two ends of the waterproof pressing strip (68) each bend towards a side on which the second metal section (50) is located, to form a bend, so that two ends of the waterproof rubber strip each form a bend.

## Patentansprüche

1. Wasserdichtes Gehäuse, das einen Gehäusekörper (10) und eine Türplatte (20) umfasst, **dadurch gekennzeichnet, dass**
die Peripherie der Türplatte mit einem ersten Metallabschnitt (30) umhüllt ist, der einen U-förmigen Querschnitt aufweist;
ein zweiter Metallabschnitt (50) von einer Seite des ersten Metallabschnitts (30), die dem Gehäusekörper (10) zugewandt ist, hervorragt; und
der zweite Metallabschnitt (50) mit einer wasserdichten Vorrichtung (60) gegen den ersten Metallabschnitt (30) ausgestattet ist; die wasserdichte Vorrichtung (60) dazu konfiguriert ist, an dem Gehäuseköper (10) anzuliegen, wenn die Türplatte (20) und der Gehäusekörper (10) geschlossen sind;
wobei die wasserdichte Vorrichtung (60) einen wasserdichten Gummistreifen (61) umfasst; der wasserdichte Gummistreifen (61) entsprechend durch einen wasserdichten Zusammendrückstreifen (62) zusammengedrückt wird, der dazu konfiguriert ist, den wasserdichten Gummistreifen (61) so zusammenzudrücken, dass er einen U-förmigen Schlitz bildet; die wasserdichte Vorrichtung (60) durch einen Bolzen, der durch den wasserdichten Zusammendrückstreifen (62), den wasserdichten Gummistreifen (61) und den zweiten Metallabschnitt (50) hindurchgeht, auf dem zweiten Metallabschnitt (50) angeordnet ist; wobei der wasserdichte Gummistreifen (61) eine Verbindungsoberfläche und zwei Kontaktoberflächen umfasst; die Verbindungsoberfläche des wasserdichten Gummistreifens (61) dazu konfiguriert ist, den zweiten Metallabschnitt (50) zu verbinden; eine Kontaktoberfläche des wasserdichten Gummistreifens (61) dazu konfiguriert ist, eine Seite des ersten Metallabschnitts (30), die dem Gehäusekörper (10) entspricht, zu kontaktieren; und die andere Kontaktoberfläche des wasserdichten Gummistreifens (61) dazu konfiguriert ist, an dem Gehäusekörper (10) anzuliegen, wenn die Türplatte (20) und der Gehäusekörper (10) geschlossen sind.

2. Wasserdichtes Gehäuse nach Anspruch 1, wobei zwei Enden (621) des wasserdichten Zusammendrückstreifens (62) jeweils zu einer Seite hin, auf der sich der zweite Metallabschnitt (50) befindet, gebogen sind, um einen Bogen (621) zu bilden, so dass zwei Enden des wasserdichten Gummistreifens (61) jeweils einen Bogen bilden.

3. Wasserdichtes Gehäuse, das einen Gehäusekörper (10) und eine Türplatte (20) umfasst, **dadurch gekennzeichnet, dass**
die Peripherie der Türplatte (20) mit einem ersten Metallabschnitt (30) umhüllt ist,
der einen U-förmigen Querschnitt aufweist;
ein zweiter Metallabschnitt (50) von einer Seite des ersten Metallabschnitts (30), die dem Gehäusekörper (10) zugewandt ist, hervorragt; und
der zweite Metallabschnitt (50) mit einer wasserdichten Vorrichtung (60) gegen den ersten Metallabschnitt (30) ausgestattet ist; die wasserdichte Vorrichtung (60) dazu konfiguriert ist, an dem Gehäusekörper (10) anzuliegen, wenn die Türplatte (20) und der Gehäusekörper (10) geschlossen sind;
wobei ein dritter Metallabschnitt (70) von einer Seite des zweiten Metallabschnitts (50), die einer Richtung zugewandt ist, in der die wasserdichte Vorrichtung (60) angeordnet ist, hervorragt; die wasserdichte Vorrichtung (60) einen wasserdichten Gummistreifen (65) und einen anderen wasserdichten Gummistreifen (72), der auf einer Seite des dritten Metallabschnitts (70) angeordnet ist, die dem Gehäusekörper (10) entspricht, umfasst; und der eine wasserdichte Gummistreifen (65) entsprechend von einem wasserdichten Zusammendrückstreifen (66) zusammengedrückt wird, der dazu konfiguriert ist, den einen wasserdichten Gummistreifen (65) so zusammenzudrücken, dass er einen Schlitz bildet; wobei
der eine wasserdichte Gummistreifen (65) eine Verbindungsoberfläche und zwei Kontaktoberflächen umfasst; der andere wasserdichte Gummistreifen (72) eine Verbindungsoberfläche und eine Kontaktoberfläche umfasst; die Verbindungsoberfläche des einen wasserdichten Gummistreifens (65) dazu konfiguriert ist, den zweiten Metallabschnitt (50) zu verbinden; eine Kontaktoberfläche des einen wasserdichten Gummistreifens (65) dazu konfiguriert ist, eine Seite des ersten Metallabschnitts (30), die dem Gehäusekörper (10) entspricht, zu kontaktieren; die andere Kontaktoberfläche des einen wasserdichten Gummistreifens (65) dazu konfiguriert ist, eine Seite des dritten Metallabschnitts (70), die der Türplatte (20) entspricht, zu kontaktieren; die Verbindungsoberfläche des anderen wasserdichten Gummistreifens (72) dazu konfiguriert ist, eine Seite des dritten Metallabschnitts (70), die dem Gehäusekörper (10) entspricht, zu verbinden; und die Kontaktoberfläche des anderen wasserdichten Gummistreifens (72) dazu konfiguriert ist, an dem Gehäusekörper (10) anzuliegen, wenn die Türplatte (20) und der Gehäusekörper (10) geschlossen sind.

4. Wasserdichtes Gehäuse nach Anspruch 3, wobei zwei Enden des wasserdichten Zusammendrückstreifens (66) jeweils zu einer Seite hin, auf der sich der zweite Metallabschnitt (50) befindet, gebogen sind, um einen Bogen zu bilden, so dass zwei Enden des wasserdichten Gummis (65) jeweils einen Bogen bilden.

5. Wasserdichtes Gehäuse, das einen Gehäusekörper (10) und eine Türplatte (20) umfasst, **dadurch gekennzeichnet, dass**
die Peripherie der Türplatte (20) mit einem ersten Metallabschnitt (30) umhüllt ist, der einen U-förmigen Querschnitt aufweist;
ein zweiter Metallabschnitt (50) von einer Seite des ersten Metallabschnitts (30), die dem Gehäusekörper (10) zugewandt ist, hervorragt; und
der zweite Metallabschnitt (50) mit einer wasserdichten Vorrichtung (60) gegen den ersten Metallabschnitt (30) ausgestattet ist; die wasserdichte Vorrichtung (60) dazu konfiguriert ist, an dem Gehäusekörper (10) anzuliegen, wenn die Türplatte (20) und der Gehäusekörper (10) geschlossen sind;
wobei ein dritter Metallabschnitt (70) von einer Seite des zweiten Metallabschnitts (50), die einer Richtung zugewandt ist, in der die wasserdichte Vorrichtung (60) angeordnet ist, hervorragt; die wasserdichte Vorrichtung (60) einen wasserdichten Gummistreifen (63) und einen anderen wasserdichten Gummistreifen (71), der auf den dritten Metallabschnitt (70) gestülpt ist, umfasst; und der eine wasserdichte Gummistreifen (63) entsprechend von einem wasserdichten Zusammendrückstreifen (64) zusammengedrückt wird, der dazu konfiguriert ist, den wasserdichten Gummistreifen so zusammenzudrücken, dass er einen Schlitz bildet; wobei der eine wasserdichte Gummistreifen (63) eine Verbindungsoberfläche und zwei Kontaktoberflächen umfasst; der andere wasserdichte Gummistreifen (71) eine Verbindungsoberfläche und zwei Kontaktoberflächen umfasst; die Verbindungsoberfläche des einen wasserdichten Gummistreifens (63) dazu konfiguriert ist, den zweiten Metallabschnitt (50) zu verbinden; eine Kontaktoberfläche des einen wasserdichten Gummistreifens (63) dazu konfiguriert ist, eine Seite des ersten Metallabschnitts (30), die dem Gehäusekörper (10) entspricht, zu kontaktieren; die andere Kontaktoberfläche des einen wasserdichten Gummistreifens (67) dazu konfiguriert ist, eine Kontaktoberfläche des anderen wasserdichten Gummistreifens (71) zu kontaktieren; die Verbindungsoberfläche des anderen wasserdichten Gummistreifens (71) dazu konfiguriert ist, eine Seite des dritten Metallabschnitts (70), die dem Gehäusekörper (10) entspricht, und eine Seite des dritten Metallabschnitts (70), die der Türplatte (20) entspricht, zu verbinden; und die andere Kontaktoberfläche des anderen wasserdichten Gummistreifens (71) dazu konfiguriert ist, an dem Gehäusekörper (10) anzuliegen, wenn die Türplatte (20) und der Gehäusekörper (10) geschlossen sind.

6. Wasserdichtes Gehäuse nach Anspruch 5, wobei zwei Enden des wasserdichten Zusammendrückstreifens (64) jeweils zu einer Seite hin, auf der sich der zweite Metallabschnitt (50) befindet, gebogen sind, um einen Bogen zu bilden, so dass zwei Enden des wasserdichten Gummistreifens jeweils einen Bogen bilden.

7. Wasserdichtes Gehäuse, das einen Gehäusekörper (10) und eine Türplatte (20) umfasst, **dadurch gekennzeichnet, dass**
die Peripherie der Türplatte (20) mit einem ersten Metallabschnitt (30) umhüllt ist, der einen U-förmigen Querschnitt aufweist;
ein zweiter Metallabschnitt (50) von einer Seite des ersten Metallabschnitts (30), die dem Gehäusekörper (10) zugewandt ist, hervorragt; und
der zweite Metallabschnitt (50) mit einer wasserdichten Vorrichtung (60) gegen den ersten Metallabschnitt (30) ausgestattet ist; die wasserdichte Vorrichtung (60) dazu konfiguriert ist, an dem Gehäusekörper (10) anzuliegen, wenn die Türplatte (20) und der Gehäusekörper (10) geschlossen sind;
wobei ein dritter Metallabschnitt (70) von einer Seite des zweiten Metallabschnitts (50), die einer Richtung zugewandt ist, in der die wasserdichte Vorrichtung (60) angeordnet ist, hervorragt; die wasserdichte Vorrichtung (60) einen wasserdichten Gummistreifen (67) und einen anderen wasserdichten Gummistreifen (72), der auf einer Seite des dritten Metallabschnitts (70), die dem Gehäusekörper (10) entspricht, angeordnet ist, umfasst; und der eine wasserdichte Gummistreifen (67) entsprechend von einem wasserdichten Zusammendrückstreifen (68) zusammengedrückt wird, der dazu konfiguriert ist, den einen wasserdichten Gummistreifen (67) so zusammenzudrücken, dass er einen Schlitz bildet; wobei
der eine wasserdichte Gummistreifen (67) eine Verbindungsoberfläche und eine Kontaktoberfläche umfasst; der andere wasserdichte Gummistreifen (72) eine Verbindungsoberfläche und eine Kontaktoberfläche umfasst; die Verbindungsoberfläche des einen wasserdichten Gummistreifens (67) dazu konfiguriert ist, den zweiten Metallabschnitt (50) zu verbinden; die Kontaktoberfläche des einen wasserdichten Gummistreifens dazu konfiguriert ist, eine Seite des ersten Metallabschnitts (30), die dem Gehäusekörper (10) entspricht, zu kontaktieren; die Verbindungsoberfläche des anderen wasserdichten Gummistreifens dazu konfiguriert ist, eine Seite des dritten Metallabschnitts (70), die dem Gehäusekörper (10) entspricht, zu verbinden; und die Kontaktoberfläche des anderen wasserdichten Gummistreifens dazu konfiguriert ist, mit dem Gehäusekörper (10) zusammenzupassen, wenn die Türplatte (20) und der Gehäusekörper (10) geschlossen sind.

8. Wasserdichtes Gehäuse nach Anspruch 7, wobei zwei Enden des wasserdichten Zusammendrückstreifens (68) jeweils zu einer Seite hin, auf der sich der zweite Metallabschnitt (50) befindet, gebogen sind, um einen Bogen zu bilden, so dass zwei Enden des einen wasserdichten Gummistreifens (65) jeweils einen Bogen bilden.

9. Wasserdichtes Gehäuse, das einen Gehäusekörper (10) und eine Türplatte (20) umfasst, **dadurch gekennzeichnet, dass**
die Peripherie der Türplatte (20) mit einem ersten Metallabschnitt (30) umhüllt ist, der einen U-förmigen Querschnitt aufweist;
ein zweiter Metallabschnitt (50) von einer Seite des ersten Metallabschnitts (30), die dem Gehäusekörper (10) zugewandt ist, hervorragt; und
der zweite Metallabschnitt (50) mit einer wasserdichten Vorrichtung (60) gegen den ersten Metallabschnitt (30) ausgestattet ist; die wasserdichte Vorrichtung (60) dazu konfiguriert ist, an dem Gehäusekörper (10) anzuliegen, wenn die Türplatte (20) und
der Gehäusekörper (10) geschlossen sind;
wobei ein dritter Metallabschnitt (70) von einer Seite des zweiten Metallabschnitts (50), die einer Richtung zugewandt ist, in der die wasserdichte Vorrichtung (60) angeordnet ist, hervorragt; die wasserdichte Vorrichtung (60) einen wasserdichten Gummistreifen (67) und einen anderen wasserdichten Gummistreifen (73), der auf den dritten Metallabschnitt (70) gestülpt ist, umfasst; und der eine wasserdichte Gummistreifen (67) entsprechend von einem wasserdichten Zusammendrückstreifen (68) zusammengedrückt wird, der dazu konfiguriert ist, den einen wasserdichten Gummistreifen (67) so zusammenzudrücken, dass er einen Schlitz bildet; wobei
der eine wasserdichte Gummistreifen (67) eine Verbindungsoberfläche und eine Kontaktoberfläche umfasst; der andere wasserdichte Gummistreifen (73) eine Verbindungsoberfläche und eine Kontaktoberfläche umfasst; die Verbindungsoberfläche des einen wasserdichten Gummistreifens (67) dazu konfiguriert ist, den zweiten Metallabschnitt (50) zu verbinden; die Kontaktoberfläche des einen wasserdichten Gummistreifens (67) dazu konfiguriert ist, eine Seite des ersten Metallabschnitts (30), die dem Gehäusekörper (10) entspricht, zu kontaktieren; die Verbindungsoberfläche des anderen wasserdichten Gummistreifens (73) dazu konfiguriert ist, eine Seite des dritten Metallabschnitts (70), die dem Gehäusekörper (10) entspricht, und eine Seite des dritten Metallabschnitts (70), die der Türplatte (20) entspricht, zu verbinden; und die Kontaktoberfläche des anderen wasserdichten Gummistreifens (73) dazu konfiguriert ist, mit dem Gehäusekörper (10) zusammenzupassen, wenn die Türplatte (20) und der Gehäusekörper (10) geschlossen sind.

10. Wasserdichtes Gehäuse nach Anspruch 9, wobei zwei Enden des wasserdichten Zusammendrückstreifens (68) jeweils zu einer Seite hin, auf der sich der zweite Metallabschnitt (50) befindet, gebogen sind, um einen Bogen zu bilden, so dass zwei Enden des wasserdichten Gummistreifens jeweils einen Bogen bilden.

## Revendications

1. Armoire étanche à l'eau, comprenant un corps d'armoire (10) et une plaque de porte (20), **caractérisée en ce que** :
la périphérie de la plaque de porte est enveloppée avec une première section métallique (30) présentant une section transversale en forme de U ;
une deuxième section métallique (50) fait saillie par rapport à un côté de la première section métallique (30), en regard du corps d'armoire (10) ; et
la deuxième section métallique (50) est pourvue d'un dispositif étanche à l'eau (60) contre la première section métallique (30) ; le dispositif étanche à l'eau (60) est conçu pour venir en butée sur le corps d'armoire (10) quand la plaque de porte (20) et le corps d'armoire (10) se ferment ;
dans laquelle le dispositif étanche à l'eau (60) comprend une bande en caoutchouc étanche à l'eau (61) ; la bande en caoutchouc étanche à l'eau (61) est respectivement plaquée par une bande de placage étanche à l'eau (62), conçue pour plaquer la bande en caoutchouc étanche à l'eau (61) afin de former une fente en forme de U ; le
dispositif étanche à l'eau (60) est disposé sur la deuxième section métallique (50) par un boulon traversant la bande de plaquage étanche à l'eau (62), la bande de caoutchouc étanche à l'eau (61) et la deuxième section métallique (50) ;
dans laquelle la bande de caoutchouc étanche à l'eau (61) comprend une surface de connexion et deux surfaces de contact ; la surface de connexion de la bande en caoutchouc étanche à l'eau (61) est conçue pour connecter la deuxième section métallique (50) ; une surface de contact de la bande en caoutchouc étanche à l'eau (61) est conçue pour entrer en contact avec un côté de la première section métallique (30) correspondant au corps d'armoire (10) ; et l'autre surface de contact de la bande en caoutchouc étanche à l'eau (61) est conçue pour venir en butée sur le corps d'armoire (10) quand la plaque de porte (20) et le corps d'armoire (10) se ferment.

2. Armoire étanche à l'eau selon la revendication 1, dans laquelle deux extrémités (621) de la bande de plaquage étanche à l'eau (62) se plient chacune vers un côté sur lequel se trouve la deuxième section métallique (50), afin de former un coude (621), de sorte que deux extrémités de la bande en caoutchouc étanche à l'eau (61) forment chacune un coude.

3. Armoire étanche à l'eau, comprenant un corps d'armoire (10) et une plaque de porte (20), **caractérisée en ce que** :
la périphérie de la plaque de porte (20) est enveloppée avec une première section métallique (30) présentant une section transversale en forme de U ;
une deuxième section métallique (50) fait saillie par rapport à un côté de la première section métallique (30), en regard du corps d'armoire (10) ; et
la deuxième section métallique (50) est pourvue d'un dispositif étanche à l'eau (60) contre la première section métallique (30) ; le dispositif étanche à l'eau (60) est conçu pour venir en butée sur le corps d'armoire (10) quand la plaque de porte (20) et le corps d'armoire (10) se ferment ;
dans laquelle une troisième section métallique (70) fait saillie par rapport à un côté de la deuxième section métallique (50), en regard d'une direction dans laquelle se trouve le dispositif étanche à l'eau (60) ; le dispositif étanche à l'eau (60) comprend une bande en caoutchouc étanche à l'eau (65) et une autre bande en caoutchouc étanche à l'eau (72) disposées sur un côté de la troisième section métallique (70) correspondant au corps d'armoire (10) ; et la bande en caoutchouc étanche à l'eau (65) est respectivement plaquée par une bande de placage étanche à l'eau (66), conçue pour plaquer la bande en caoutchouc étanche à l'eau (65) afin de former une fente ;
dans laquelle la bande de caoutchouc étanche à l'eau (65) comprend une surface de connexion et deux surfaces de contact ; l'autre bande de caoutchouc étanche à l'eau (72) comprend une surface de connexion et une surface de contact ; la surface de connexion de la bande en caoutchouc étanche à l'eau (65) est conçue pour connecter la deuxième section métallique (50) ; une surface de contact de la bande en caoutchouc étanche à l'eau (65) est conçue pour entrer en contact avec un côté de la première section métallique (30) correspondant au corps d'armoire (10) ; l'autre surface de contact de la bande en caoutchouc étanche à l'eau (65) est conçue pour entrer en contact avec un côté de la troisième section métallique (70) correspondant à la plaque de porte (20) ; la surface de connexion de l'autre bande en caoutchouc étanche à l'eau (72) est conçue pour connecter un côté de la troisième section métallique (70) correspondant au corps d'armoire (10) ; et la surface de contact de l'autre bande en caoutchouc étanche à l'eau (72) est conçue pour venir en butée sur le corps d'armoire (10) quand la plaque de porte (20) et le corps d'armoire (10) se ferment.

4. Armoire étanche à l'eau selon la revendication 3, dans laquelle deux extrémités de la bande de plaquage étanche à l'eau (66) se plient chacune vers un côté sur lequel se trouve la deuxième section métallique (50), afin de former un coude, de sorte que deux extrémités du caoutchouc étanche à l'eau (65) forment chacune un coude.

5. Armoire étanche à l'eau, comprenant un corps d'armoire (10) et une plaque de porte (20), **caractérisée en ce que** :
la périphérie de la plaque de porte (20) est enveloppée avec une première section métallique (30) présentant une section transversale en forme de U ;
une deuxième section métallique (50) fait saillie par rapport à un côté de la première section métallique (30), en regard du corps d'armoire (10) ; et
la deuxième section métallique (50) est pourvue d'un dispositif étanche à l'eau (60) contre la première section métallique (30) ; le dispositif étanche à l'eau (60) est conçu pour venir en butée sur le corps d'armoire (10) quand la plaque de porte (20) et le corps d'armoire (10) se ferment ;
dans laquelle une troisième section métallique (70) fait saillie par rapport à un côté de la deuxième section métallique (50), en regard d'une direction dans laquelle se trouve le dispositif étanche à l'eau (60) ; le dispositif étanche à l'eau (60) comprend une bande en caoutchouc étanche à l'eau (63) et une autre bande en caoutchouc étanche à l'eau (71) chemisées sur la troisième section métallique (70) ; et la bande en caoutchouc étanche à l'eau (63) est respectivement plaquée par une bande de placage étanche à l'eau (64), conçue pour plaquer la bande en caoutchouc étanche à l'eau afin de former une fente ;
dans laquelle la bande de caoutchouc étanche à l'eau (63) comprend une surface de connexion et deux surfaces de contact ;
l'autre bande de caoutchouc étanche à l'eau (71) comprend une surface de connexion et deux surfaces de contact ;
la surface de connexion de la bande en caoutchouc étanche à l'eau (63) est conçue pour connecter la deuxième section métallique (50) ; une surface de contact de la bande en caoutchouc étanche à l'eau (63) est conçue pour entrer en contact avec un côté de la première section métallique (30) correspondant au corps d'armoire (10) ;
l'autre surface de contact de la bande en caoutchouc étanche à l'eau (67) est conçue pour entrer en contact avec une surface de contact de l'autre bande en caoutchouc étanche à l'eau (71) ; la surface de connexion de l'autre bande en caoutchouc étanche à l'eau (71) est conçue pour connecter un côté de la troisième section métallique (70) correspondant au corps d'armoire (10), et un côté de la troisième section métallique (70) correspondant à la plaque de porte (20) ; et l'autre surface de contact de l'autre bande en caoutchouc étanche à l'eau (71) est conçue pour venir en butée sur le corps d'armoire (10) quand la plaque de porte (20) et le corps d'armoire (10) se ferment.

6. Armoire étanche à l'eau selon la revendication 5, dans laquelle deux extrémités de la bande de plaquage étanche à l'eau (64) se plient chacune vers un côté sur lequel se trouve la deuxième section métallique (50), afin de former un coude, de sorte que deux extrémités de la bande en caoutchouc étanche à l'eau forment chacune un coude.

7. Armoire étanche à l'eau, comprenant un corps d'armoire (10) et une plaque de porte (20), **caractérisée en ce que** :
la périphérie de la plaque de porte (20) est enveloppée avec une première section métallique (30) présentant une section transversale en forme de U ;
une deuxième section métallique (50) fait saillie par rapport à un côté de la première section métallique (30), en regard du corps d'armoire (10) ; et
la deuxième section métallique (50) est pourvue d'un dispositif étanche à l'eau (60) contre la première section métallique (30) ; le dispositif étanche à l'eau (60) est conçu pour venir en butée sur le corps d'armoire (10) quand la plaque de porte (20) et le corps d'armoire (10) se ferment ;
dans laquelle une troisième section métallique (70) fait saillie par rapport à un côté de la deuxième section métallique (50), en regard d'une direction dans laquelle se trouve le dispositif étanche à l'eau (60) ; le dispositif étanche à l'eau (60) comprend une bande en caoutchouc étanche à l'eau (67) et une autre bande en caoutchouc étanche à l'eau (72) disposées sur un côté de la troisième section métallique (70) correspondant au corps d'armoire (10) ; et la bande en caoutchouc étanche à l'eau (67) est respectivement plaquée par une bande de placage étanche à l'eau (68), conçue pour plaquer la bande en caoutchouc étanche à l'eau (67) afin de former une fente ; dans laquelle
la bande de caoutchouc étanche à l'eau (67) comprend une surface de connexion et une surface de contact ; l'autre bande de caoutchouc étanche à l'eau (72) comprend une surface de connexion et une surface de contact ; la surface de connexion de la bande en caoutchouc étanche à l'eau (67) est conçue pour connecter la deuxième section métallique (50) ; la surface de contact de la bande en caoutchouc étanche à l'eau est conçue pour entrer en contact avec un côté de la première section métallique (30) correspondant au corps d'armoire (10) ; la surface de connexion de l'autre bande en caoutchouc étanche à l'eau est conçue pour connecter un côté de la troisième section métallique (70) correspondant au corps d'armoire (10) ; et la
surface de contact de l'autre bande en caoutchouc étanche à l'eau est conçue pour s'adapter au corps d'armoire (10) quand la plaque de porte (20) et le corps d'armoire (10) se ferment.

8. Armoire étanche à l'eau selon la revendication 7, dans laquelle deux extrémités de la bande de plaquage étanche à l'eau (68) se plient chacune vers un côté sur lequel se trouve la deuxième section métallique (50), afin de former un coude, de sorte que deux extrémités de la bande en caoutchouc étanche à l'eau (65) forment chacune un coude.

9. Armoire étanche à l'eau, comprenant un corps d'armoire (10) et une plaque de porte (20), **caractérisée en ce que** :
la périphérie de la plaque de porte (20) est enveloppée avec une première section métallique (30) présentant une section transversale en forme de U ;
une deuxième section métallique (50) fait saillie par rapport à un côté de la première section métallique (30), en regard du corps d'armoire (10) ; et
la deuxième section métallique (50) est pourvue d'un dispositif étanche à l'eau (60) contre la première section métallique (30) ; le dispositif étanche à l'eau (60) est conçu pour venir en butée sur le corps d'armoire (10) quand la plaque de porte (20) et le corps d'armoire (10) se ferment ;
dans laquelle une troisième section métallique (70) fait saillie par rapport à un côté de la deuxième section métallique (50), en regard d'une direction dans laquelle se trouve le dispositif étanche à l'eau (60) ; le dispositif étanche à l'eau (60) comprend une bande en caoutchouc étanche à l'eau (67) et une autre bande en caoutchouc étanche à l'eau (73) chemisées sur la troisième section métallique (70) ; et la bande en caoutchouc étanche à l'eau (67) est respectivement plaquée par une bande de placage étanche à l'eau (68), conçue pour plaquer la bande en caoutchouc étanche à l'eau (67) afin de former une fente ; dans laquelle
la bande de caoutchouc étanche à l'eau (67) comprend une surface de connexion et une surface de contact ; l'autre bande de caoutchouc étanche à l'eau (73) comprend une surface de connexion et une surface de contact ; la surface de connexion de la bande en caoutchouc étanche à l'eau (67) est conçue pour connecter la deuxième section métallique (50) ; la surface de contact de la bande en caoutchouc étanche à l'eau (67) est conçue pour entrer en contact avec un côté de la première section métallique (30) correspondant au corps d'armoire (10) ; la surface de connexion de l'autre bande en caoutchouc étanche à l'eau (73) est conçue pour connecter un côté de la troisième section métallique (70) correspondant au corps d'armoire (10), et un côté de la troisième section métallique (70) correspondant à la plaque de porte (20) ;
et la surface de contact de l'autre bande en caoutchouc étanche à l'eau (73) est conçue pour s'adapter au corps d'armoire (10) quand la plaque de porte (20) et le corps d'armoire (10) se ferment.

10. Armoire étanche à l'eau selon la revendication 9, dans laquelle deux extrémités de la bande de plaquage étanche à l'eau (68) se plient chacune vers un côté sur lequel se trouve la deuxième section métallique (50), afin de former un coude, de sorte que deux extrémités de la bande en caoutchouc étanche à l'eau forment chacune un coude.
